# EUROPEAN PATENT APPLICATION

(11) **EP 4 530 649 A1**
(43) Date of publication of application: **02.04.2025**
(21) Application number: 23199754.5
(22) Date of filing: 26.09.2023
(51) Int. Cl.: G01R 31/327, G01R 35/00

(54) **DEVICE AND METHOD FOR TESTING PROTECTION CIRCUITS IN HIGH-VOLTAGE GEAR/SWITCHGEAR**

(71) Applicant: General Electric Technology GmbH, 5400 Baden (CH)
(72) Inventor: JUGE, Patrice, 73100 Aix-les-Bains (FR)
(74) Representative: Rüger Abel Patentanwälte PartGmbB

(57) **Abstract**

The invention relates to a test device (20) to test a Rogowski coil (4) and an associated protection device (8) connected to said coil via conductors (13), comprising:
- means (21) to generate at least one test voltage;
- transformation means (22) to transform said test voltage into a voltage representative of a secondary signal generated by said Rogowski coil (4), said transformation means (22) comprising output terminals (231, 232) for connection to conductors (13);
- means (226) to process an output voltage of said coil.

## Description

### TECHNICAL FIELD AND PRIOR ART

Rogowski sensor are known to measure currents in Gas Insulated Switchgears (GIS).

They can be implemented on a printed circuit board, as disclosed in US5414400.

Figure 1A shows a Rogowski coil 4 according to US5414400, comprising a plate 11 of a printed circuit, for example made of epoxy resin; the coil comprises deposits of copper 3 on each face of the plate, the deposits of one face being connected to the deposits of the other face via plated through holes 5 passing through the plate. The coil has terminals 7, 9.

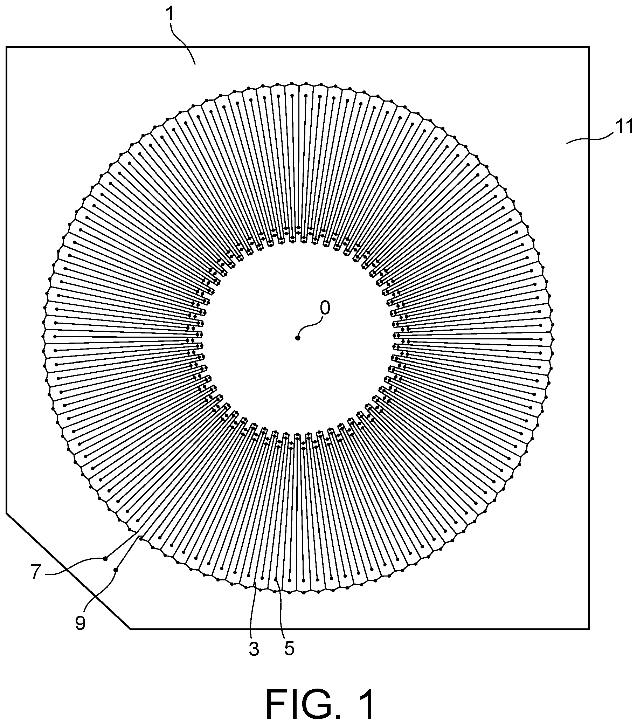

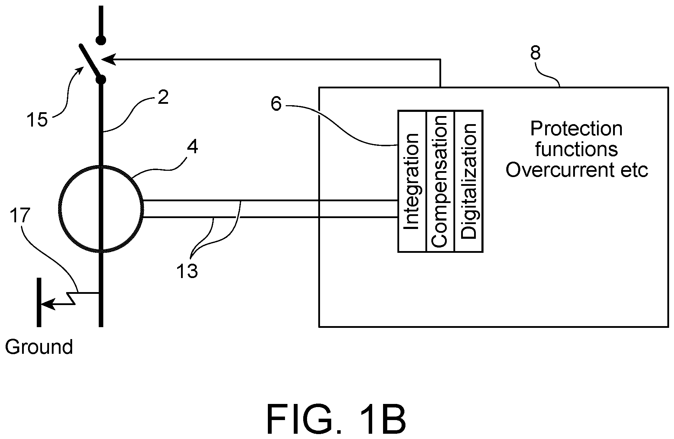

As illustrated on figure 1B, a Rogowski coil 4 is usually connected to a protection circuit 8 which can open switches or circuit breakers 15 in case of any default, for example a surge of current in the GIS or a short circuit 17. Such default can generate currents as high as several tens of A or event higher than 100 000 A, which are very dangerous both for operators and for the whole system and can result in interruptions of several months. It is necessary to test whether the protection circuit and the switches or circuit breakers 15 operate properly. But it is of course impossible to simulate a real default 17 because of the very high currents (up to 100 000 A) which are required: a portable generator can generate at most several tens or hundreds of A.

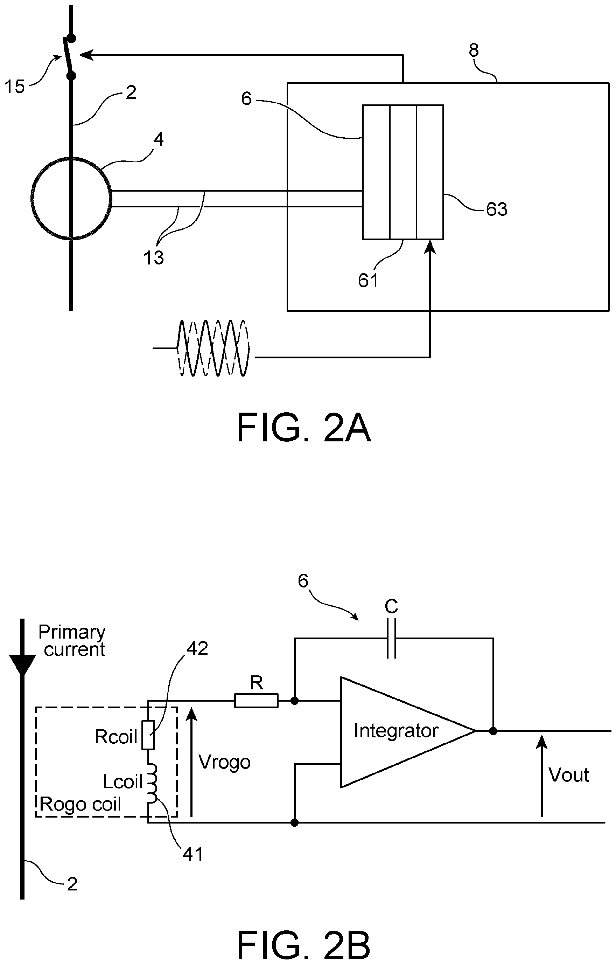

For these reasons test circuits have been developed to test the protection circuits 8, 15. A conventional test of the protection circuit is schematically illustrated on figure 2A, on which reference 2 designates a conductor around which a Rogowski coil 4 is arranged in order to measure a current circulating therein, the coil 4 generating a secondary voltage signal which is supplied to a system 8 comprising an integrator 6, a compensation stage 61 and a digitalization stage 63 in order to test the protection devices 15 against, for example, overcurrents.

More precisely, the magnetic field created by the primary current which usually circulates in conductor 2 generates a voltage at the terminals 7, 9 of the coil. This voltage is for example approximately of the order of 50 mV/kA at 50Hz. As shown on figure 2B, this voltage v_{rogo} is integrated by integrator 6; the resulting voltage Vₒᵤₜ is representative of the primary current circulating in conductor 2 and can be digitized and processed. On figure 2B, the coil is represented by an equivalent circuit comprising an inductance 41 and a resistance 42 in series.

Usually, as shown on figure 2A, a test current is directly injected into the protection system 8, in particular directly to the digitalization stage 63, in order to test the protection functions and devices 15. However, the components located upstream of the digitalization stage, in particular the wires 13 and the integrator 6 and the coil 4 itself are not tested. Furthermore, the current which is injected as a test current is not representative of the secondary voltage signal output by the coil 4; in other words, the test is performed under conditions which are not representing the actual signal generated by the coil 4 when it is measuring a current in the conductor 2.

There is thus a problem of finding a new test method and a new test device of a Rogowski coil and its associated circuit in order to overcome one or more of the above problems.

In particular, there is a need for a new test method and a new device adapted to test the protection circuit of a Rogowski coil and the conductors between said circuit and said coil.

There is also a need for a new test method and a new device adapted to generate test signals which are representative of the actual signals generated by the coil 4 when it is measuring a current in the conductor 2 and when a default (like default 17 on figure 1B) appears

### PRESENTATION OF THE INVENTION

The present invention first concerns a test device, to test for example a Rogowski coil and an associated protection device connected to said coil via conductors, comprising:
- means to generate at least one test voltage, comprising for example an overvoltage, and to apply said test voltage to the terminals of a Rogowski coil;
- means to process an output voltage of said coil.

For example, according to one embodiment of the invention, a test device to test a Rogowski coil and an associated protection device connected to said coil via conductors, comprises:
- means to generate at least one test voltage;
- transformation means to transform said test voltage into a voltage comprised between 0.5 V and 10V, representative of a secondary signal generated by said Rogowski coil, said transformation means comprising output terminals for connection to conductors;
- means to process an output voltage of said coil.

The voltage which is output by device according to the invention is representative of the output signal of a Rogowski coil.

Said transformation means can comprise a capacitive circuit, comprising for example at least 1 capacitor, for example 2 capacitors. A resistor can be arranged in parallel to said at least one capacitor.

Preferably, said at least one resistor has an impedance much smaller than the impedance of said coil and said at least one capacitor.

In a test device according to the invention, said means to generate a test voltage can comprise an alternative current generator. For example, said alternative current generator comprises a controller and preferably at least one memory storing or to store data of at least one, preferably several, waveform(s) which can be used for testing.

In a test device according to the invention, said transformation means can comprise one or more electrical components, for example at least one resistor and/or at least one capacitor, and can further comprise means to vary at least one electrical characteristic at least one of said electronic components.

Said at least one electrical characteristic of at least one of said electronic components can be varied on the basis of one or more tests performed on a Rogowski coil tested with a device according to the invention.

In an embodiment, said transformation means can comprise terminals to provide said means to process with a signal from a Rogowski coil under test.

The invention also concerns a Rogowski coil and an associated protection system connected to said coil via conductors, said conductors comprising connectors to connect a test device according to the invention.

Said Rogowski coil can further comprise a memory storing one more characteristic, for example the sensitivity and/or the resistance and/or the inductance, of said coil. One or more conductors can connect said memory to at least one part, for example a compensation stage, of said protection system.

Said protection system can comprise one or more switch(es) and/or one or more circuit breaker(s), the test device comprising means to detect whether at least one switch or at least one circuit breaker opens when a default is detected.

The invention applies to a single-phase conductor or to one or more phase(s) of a system having several, for example 3, phases. Thus, the invention also concerns a single phase or a 3 phase GIS, comprising at least one conductor, at least one Rogowski coil around said at least one conductor and at least one test device according to the invention.

The invention also concerns a method to test a Rogowski coil according to the invention, said coil being arranged around a main conductor, said method comprising:
- interrupting any primary current circulating in said main conductor;
- connecting a test device according to the invention to said conductors;
- injecting in said conductors one or more test signal(s) generated by said test device;
- processing a signal from said coil to decide whether the coil and its protection system is defective or not, for example by detecting whether said protection system is triggered.

In a device or a method according to the invention, a protection system connected to a Rogowski coil can comprise one or more of :
- integration means, or an integration stage or device,
- compensation means, or a compensation stage or device;
- digitization means or a digitalization stage or device;
- signal filtering means, or a filtering stage or device;
- protection means, for example one or more switch(es) and/or one or more circuit breaker(s).

### BRIEF DESCRIPTION OF THE DRAWINGS

- Figure 1A shows an embodiment of a Rogowski coil according to the prior art;
- Figure 1B illustrates a default and the opening of a circuit breaker according to the prior art;
- Figures 2A and 2B show a test system according to the prior art;
- Figure 3 shows a test system according to the invention;
- Figure 4 shows an embodiment of a test circuit according to the invention;
- Figure 5 shows an equivalent diagram of the circuit of figure 4;
- Figure 6 shows a 3-phase system, comprising 3 conductors, each associated with a Rogowski coil, one or more of the coils being able to be provided with a device according to the invention;
- Figure 7 shows a measuring system associated with a Rogowski coil which can be provided with a device according to the invention;
- Figure 8 shows a test signal and the detected secondary signal;
- Figures 9A-9C show examples of voltage (figure 9A) and current (figure 9B) waveforms, including a simulated default, figure 9C showing an expanded portion of figure 9B.

### DETAILED PRESENTATION OF PARTICULAR EMBODIMENTS

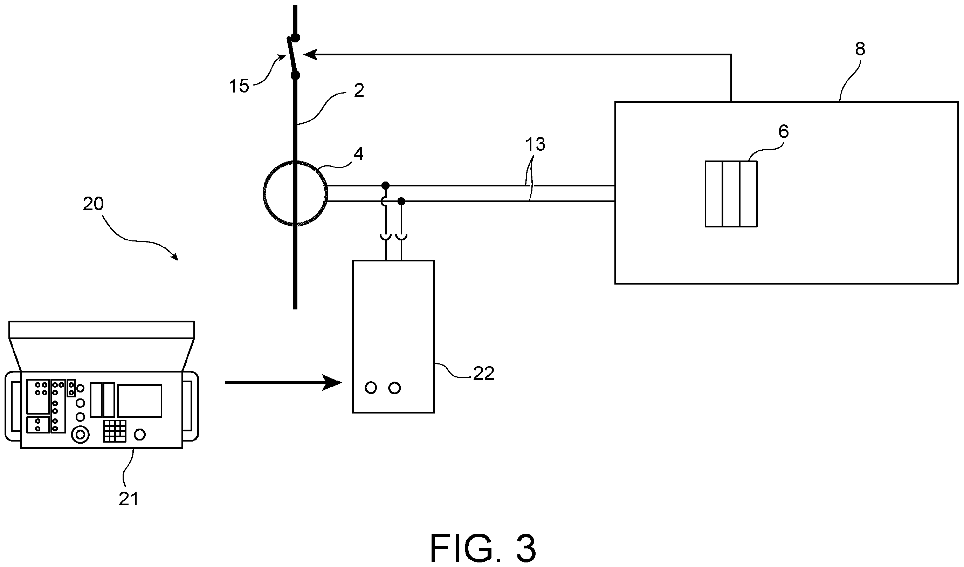

An embodiment of the present invention is shown on figure 3.

It is applied to a Rogowski coil 4, for example as disclosed above in connection with figure 1A, said coil 4 being arranged around a conductor 2 in order to measure a current circulating in said conductor. The coil 4 generates a secondary voltage signal which is supplied to an integrator 6 forming part of protection system 8 which controls one or more protection device(s), for example one or more switch(es) and/or circuit breaker(s) 15, in case, for example, of overcurrents.

A test device 20 according to one embodiment of the invention is connected to the conductors 13, between the coil 4 and the integrator 6, in order to inject in said conductors a current representative of a signal at the terminals of coil 4 when it is measuring a current circulating in conductor 2. In other words, a test current of some A or some tens of A, for example between 1A and 50 A or 100 A, results in a current at the outlet of the test device 20 very comparable to the current generated by the coil when a primary current of several tens of kA circulates in conductor 2.

Test device 20 comprises for example a current generator or source 21 able to generate a current of for example between 0 and 100 A and an interface tool or device 22. Alternatively, a voltage source could be used instead of the current source and of the impedance 220 (see below) but it is preferable to use a current source in order to simulate a primary current.

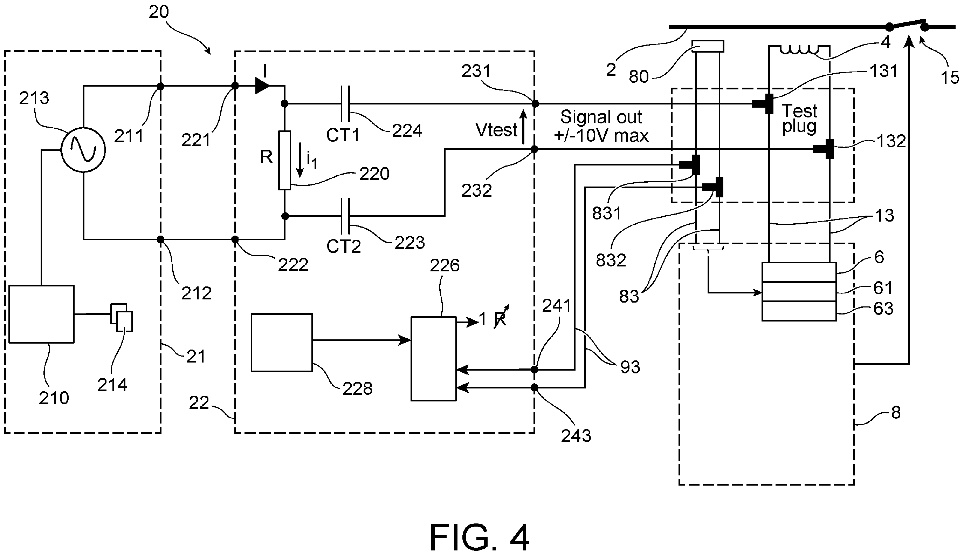

Figure 4 shows a more detailed representation of an embodiment of test device 20.

The generator 21 comprises an electronic circuit 210 which controls an AC source 213 to generate a 1^{st} alternating voltage between its outlet terminals 211, 212. Said terminals can be connected to inlet terminals 221, 222 of the interface device 22. Thus generator 21 is able to supply a voltage (1^{st} alternating voltage) to the interface device 22. This 1^{st} alternating voltage applied to a resistor 220 and capacitors 223, 224 of the interface device is able to generate a test voltage Vₜₑₛₜ representative of the voltage at the terminals of the coil 4.

The generator 21 can further comprise one or more memory/ies 214 to store waveform data in order to simulate one or more default(s), for example over-currents or over intensities or over-voltage on one or more phases, to test the elements or components downstream of coil 4, including the protection device 8. An over-current, respectively an over-voltage, is a current, respectively a voltage, that the machine cannot accept except during a very short time: the machine has a rated current, of for example 3000 A eff, which it can permanently accept, but it can accept an overcurrent higher than the rated current, for example at least 2 times the rated current, only for a short period of time, for example for some 10 ms and some s, or between 50 ms and 5s; beyond the end of that period of time, the machine must be stopped or the current interrupted.

An operator and/or a a computer or a controller can select one or more of these data files and the electronic circuit 210 can provide the system (interface device 22) with the corresponding signal comprising or simulating said one or more simulated default(s).

Interface device 22 comprises a resistor 220 and inlet terminals 221, 222 to supply said resistor 220 with the outlet voltage provided by generator 21. Resistor 220 has a value such that the alternating current i₁ circulating therein is representative of the primary current usually circulating in conductor 2, for example between 50 and 100 kA

As explained below, the value of resistor 220 can be adapted depending on the test performed.

The terminals of the resistor can be connected, for example through one or more capacitor(s) 223, 224, to outlet terminals 231, 232 of interface device 22.

Said one or more capacitor(s) 223, 224 are test capacitors. In particular, this/these capacitor(s) will block any direct current or direct voltage component so that it is not supplied to the system comprising the conductors 13 and the protection device 8. As explained below, the value of these capacitor(s) can be adapted depending on the test performed.

The voltage between outlet terminals 231, 232 is representative of, or very comparable to, the secondary voltage at the outlet of coil 4; for example it is comprised between 0.5 V and 10V.

Interface device 22 can furthermore comprise a microcontroller 226 and a display device 228 as explained below.

Outlet terminals 231, 232 of interface device 22 can be connected to the conductors 13 (upstream of the protection system 8) via test plugs or connectors 131, 132 of said conductors. Thus, the system 20 can provide the conductors 13 with a test signal (a voltage) which is very similar to the secondary voltage generated by the coil 4 detecting a primary current in conductor 2. The test signals allow testing the conductors 13 and all other components between (and including) the coil 4 and the system 8, which comprises the integrator 6 but also a compensation stage 61 (this stage being fed with information from a memory, for example an EEPROM 80, about the sensitivity and/or the resistance and/or the inductance of the coil 4) and/or one or more filter(s) and/or one or more protection device(s) 15 (for example one or more switch(es) and/or circuit breaker(s)) to protect against defaults such as over currents or over intensities, and/or faults to ground etc.

In particular, it is thus possible to test the one or more protection device(s) of the system 8, 15: if the test device 20 injects into the conductors 13 a signal comprising one or more default(s), but the protection device does not trigger the switches or circuit-breakers 15 and/or does not interrupt the current circulating in conductor 2, then it is decided that the protection system does not work properly and should be checked and possibly repaired. In other words, the simulated default is seen by the system and it is possible to check whether a signal is generated to open the switch(es) and/or the circuit breaker(s) 15. If the protection device triggers the switches or circuit-breakers 15 or interrupts the current circulating in conductor 2, then it is decided that the protection system works properly.

A signal representing the current inside the system 8 can be derived through conductors 93 which can for example be connected to test plugs 831, 832 of conductors 83 connecting the memory 80 to the compensation stage 61. This signal can be supplied to inlet terminals 241, 243 of the interface device 22 and then, for example, to microcontroller 226 and to display device 228.

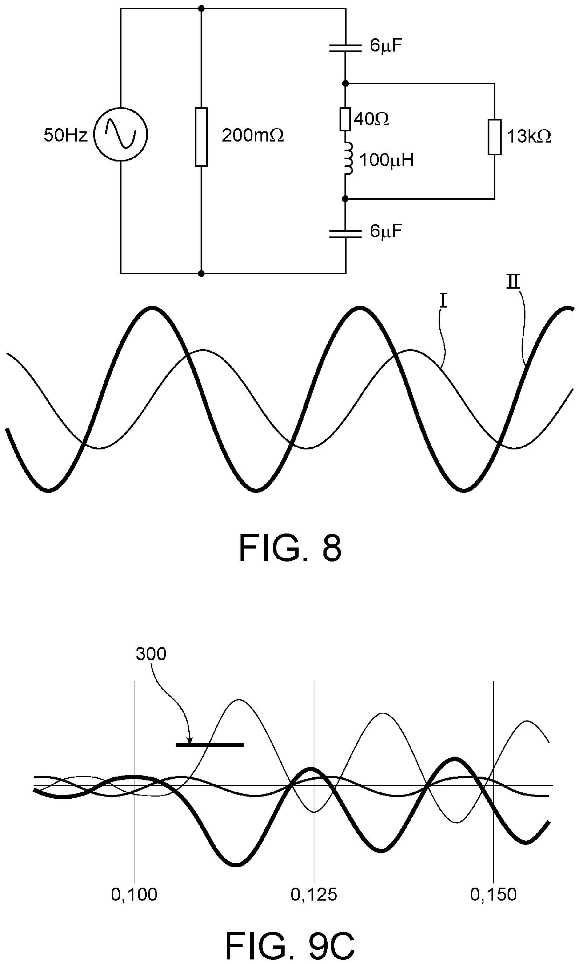

Figure 8 is an example of a test voltage (curve I) generated by a test device according to the invention, curve II (90° out of phase with respect to curve I) being the voltage measured or detected between the plugs 831, 832.

The microcontroller 226 can be programmed or adapted to regulate the parameters of the electrical components of the interface device 22, for example resistor 220 and/or capacitor(s) 223, 225, depending on the signal received from the system 8. One or more data of memory 80, in particular one or more of the above-mentioned data about the coil 4, can also be provided to microcontroller 226. Rogowski coils can have different properties from each other, in particular different sensitivities; the information about these properties, for example the sensitivity, can therefore be read from said memory 80 and can be used when regulating the electrical components of the interface device 22.

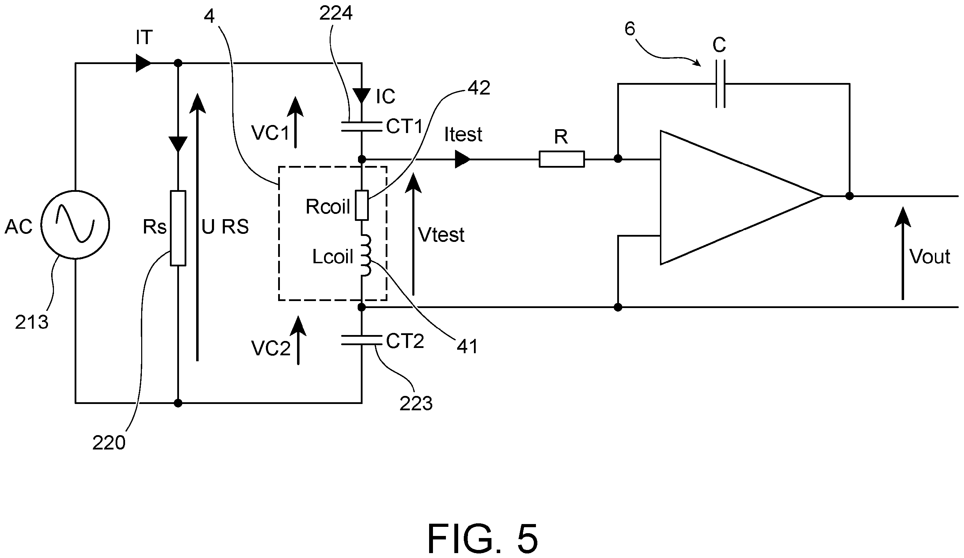

Figure 5 shows an equivalent diagram of the circuit disclosed above in connection with figure 4 together with the integration stage 6 (which forms part of the protection system 8). The references designate the same elements or components as above. Reference 213' is a current source connected to the terminals of the resistor 220. The Rogowski coil 4 is represented by resistor 42 and capacitor 41. The secondary signal generated by the coil 4 is integrated by the integrator 6

When a test according to the invention must be performed, any current circulating in the primary circuit (in the conductor 2) is interrupted. The Rogowski coil therefore does not generate any secondary voltage and is ready for a test.

For a test, the system 8 and the conductors 13 remain connected to coil 4. The interface device 22 is connected to generator 21 and to conductors 13 as shown on figure 4. The test circuit is therefore connected in parallel to the Rogowski coil 4.

The current source 213' generates a test current I_{T} which is representative of the default current, for example of a short-circuit current.

The test current overwhelmingly circulates through resistor 220 (which has an impedance R₂₂₀ which is small with respect to the impedance of the other branch of the circuit (capacitors 222, 223 and coil 4); for example: 10×R₂₂₀ < Z_{CT1} + Z₄ + Z_{CT2}.

The voltage at the terminals of 220 (for example 1V for 5 A and R₂₂₀ = 0.2 Ω) is very comparable to the voltage at the terminals of coil 4 when a primary current is circulating in conductor. The voltage U_{RS} (in phase with current I_{T}) between the terminals of resistor 220 is equal to the sum of the voltages between the terminals of the capacitors 223, 224 and of the coil 4: U_{RS} = V_{C1} + V_{C2} + Vₜₑₛₜ. Vₜₑₛₜ simulates the behaviour of Rogowski coil 4 in reaction to a primary current and depends on the respective values of the capacitors 223, 224, of resistor 42 and of inductance 41. Preferably, the values of capacitors 223, 224 and of resistor 42 are selected so that Vₜₑₛₜ is comparable to the voltage at the terminals of coil 4 when it is subject to primary current I_{T}. The values of capacitors 223, 224 are also preferably selected so that Vₜₑₛₜ is phase shifted by 90° with respect to the current generated by generator 213' as shown on figure 8 (curve I being the test voltage and curve II being the current, for a circuit illustrated on this figure and having the following characteristics: R₂₂₀ = 200 mΩ, C₂₂₄ = C₂₂₃ = 6µF ) : for this reason, their impedance is preferably much higher than the impedance L_{coil} of the coil 41 (10×Z₄₁ < Z_{CT1} + Z_{CT2})

The one or more capacitors CT1, CT2 behave like coupling capacitors allowing a derived or a test alternative current to circulate in the Rogowski coil which is in an idle state (no primary current is circulating in conductor 2). The voltage generated at the terminals of the Rogowski coil mirrors the behaviour of the coil as if it was detecting a current in conductor 2.

When a current (primary signal) circulates in conductor 2, the Rogowski coil generates a secondary signal, wherein the resistance of the coil does not play any significant role.

A test performed according to the present invention makes use of the resistance of the Rogowski coil (by circulating a current therein) to generate the secondary voltage, independently from the Rogowski effect.

Example values which can be used for a test device according to the invention are as follows:
- an effective current (rms) I_{T} of some A;
- a resistor 220 between 0.1 Ω and 1 Ω;
- an amplitude of voltage U_{RS} of about 1 V;
- capacitors 223 and 224 between 1 µF and 10 µF each;
- R_{coil} (resistance of resistor 42) between 10 Ω and 100 Ω;
- L_{coil} (inductance 41) between 10 µH and 200 µH;
- an effective voltage (rms) of Vₜₑₛₜ between 10 mV and 100 mV (for example with peak values of Vₜₑₛₜ up to 10V);
- a current Iₜₑₛₜ between 1 µA and 10 µA.

More precise values will be selected based on the actual characteristics of each system.

A test device according to the invention offers the following advantages.

The main circuit (including coil 4, conductors 13 and system 8) is protected from common mode signals through the capacitors 223, 224.

A default of the Rogowski coil (for example a cut or a short-circuit of wire 3) can be detected since it will affect Vₜₑₛₜ. Actually, the whole chain from and including the Rogowski coil 4 to the complete protection system 8, including any filtering and/or integrating stage, can be tested, which is not the case with usual digital signals directly sent to the protection system 8 (as on figure 2A).

Complex waveforms can be injected through the test circuit according to the invention, just like with conventional circuits.

A test circuit according to the invention allows injecting currents of the order of some Amp into the protection circuit 8 and the coil 4, which are representative of a primary current (in conductor 2) of several tens or hundreds of kA.

When a test device according to the invention is implemented, the primary circuit circulating in the conductor 2 is interrupted and the Rogowski coil 4 therefore does not generate any voltage. A test implementing the invention can be performed.

The invention was disclosed in connection with one conductor 2 or one phase.

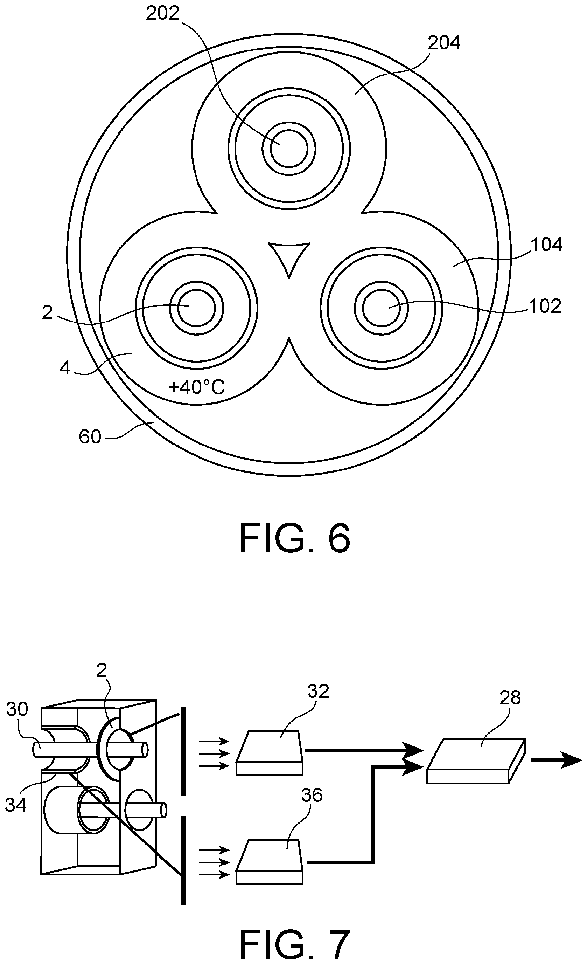

Figure 6 represents an enclosure 60 containing 3 conductors 2, 102, 202, for example conductors of a 3-phases system, a Rogowski coil 4, 104, 204 being arranged around each of said conductors. Each of these coils can be tested with a test device or a test method according to the invention. For example, the same test device 20 can successively be connected to the conductors 13 associated with each of the 3 Rogowski coils.

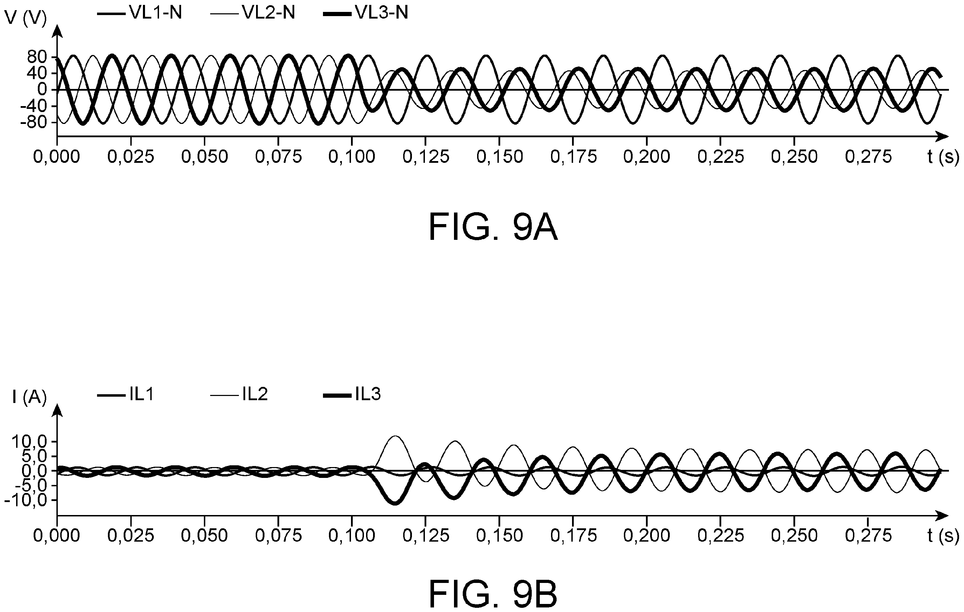

In any embodiment according to the invention, the signal from each test can be provided to a control unit, for example a computer or a controller or a microprocessor (not illustrated on the figures), to sample and/or process said signal; it can generate a test signal as shown on figure 9A, including some default(s). Figure 9A shows for each of 3 phases a test voltage including a simulated default (a sudden voltage drop on 2 phases) at about t = 0.1 which generates a surge in current i of these phases (see Figure 9B). Device 21 or 210 (figures 3, 4) can be programmed so that an alarm is triggered when the simulated current increases above a threshold 300, here at about 5A.

Figure 7 represents a Rogowski coil 4 implemented around a conductor 2. The signals from the coil can be sent to a converter 32 to convert said signal into optical signals. Other signals from one or more other sensor(s), for example a capacitive sensor 34, can also be converted by a converter 36 into optical signals. The optical signals can be merged in a merging unit 28. The merging unit can comprise a microprocessor to process data and can have calculation capabilities. Rogowski coil 4 can be tested according to the teaching of the present invention. The same system may be implemented for several coils, like for example on figure 6.

A test device 20 according to the invention can be easily disconnected from and connected to test plugs 131, 132 of the conductors 13 connected to the terminals of a Rogowski coil 4. A test according to the invention therefore does not need to implement or to activate any switching element which could create disturbances. Indeed, currents circulating on the secondary side of a Rogowski coil are rather weak: if the conductors had to be interrupted to make a test, other test, namely continuity tests, should be performed to reconnect the conductors (the contact impedance of the connections could result in a fainting of the signal).

A test device 20 according to the invention offers flexibility because the interface device 22 can be:
- disconnected from the conductors 13 and connected to the conductors 13 of another Rogowski coil;
- and/or disconnected from generator 21 and connected to another test signals generator.

## Claims

1. A test device (20) to test a Rogowski coil (4) and an associated protection device (8) connected to said coil via conductors (13), comprising:
- means (21) to generate at least one test voltage, comprising an overvoltage;
- transformation means (22) to transform said test voltage into a voltage comprised between 0.5 V and 10V, said transformation means (22) comprising output terminals (231, 232) for connection to conductors (13), said transformation means (22) comprising a capacitive circuit;
- means (226) to process an output voltage of said coil and detect whether a protection device (15) of said coil is triggered.

2. - A device as in claim 1, said transformation means (22), said capacitive circuit comprising at least one or at least 2 capacitor(s) (223, 224, CT1, CT2).

3. - A device as in claim 2, said transformation means (22) comprising at least one resistor (Rs, 220) connected in parallel to said at least one capacitor (223, 224, CT1, CT2).

4. - A device as in claim 3, said at least one resistor (Rs, 220) having an impedance much smaller than the impedance of said at least one capacitor (223, 224, CT1, CT2) and of said Rogowski coil.

5. - A device as in claim 1 to 4, said means (21) to generate a test voltage comprising an alternative current generator (21).

6. - A device is in claim 5, said alternative current generator (21) comprising a controller (210) and at least one memory (214) to store data of at least one, preferably several, waveform(s) which can be used for testing.

7. - A device as in any of claims 1 to 6, said transformation means (22) comprising one or more electrical components, for example at least one resistor (220) and/or at least one capacitor (231, 232), and further comprising means (226) to vary at least one electrical characteristic at least one of said electronic components.

8. - A device as in claim 7, said means (226) being able to vary at least one electrical characteristic of at least one of said electronic components on the basis of one or more tests performed on a coil (4).

9. - A device as in any of claims 1 to 8, said transformation means (22) comprising terminals (241, 243) to provide said means (226) with a signal from a coil (4).

10. A Rogowski coil (4) and an associated protection system (8) connected to said coil via conductors (13), comprising connectors (131, 132) on said conductors (13) to connect a test device according to any of claims 1 to 10.

11. A Rogowski coil (4) according to claim 10, further comprising a memory (80) storing one more characteristic, for example the sensitivity and/or the resistance and/or the inductance, of said coil (4).

12. A Rogowski coil (4) according to claim 11, further comprising one or more conductors (83) connecting said memory (80) to at least one part, for example a compensation stage (61), of said protection system (8).

13. A Rogowski coil (4) according to any of claims 10 to 12, said protection system (8) comprising one or more switch(es) (15) and/or one or more circuit breaker(s), the test device comprising means to detect whether at least one switch or at least one circuit breaker opens when a default is detected.

14. A single phase or a 3 phase GIS, comprising at least one conductor (2, 102, 202), at least one Rogowski coil (4, 104, 204) and at least one device as in any of claims 1 to 9.

15. A method to test a Rogowski coil according to any of claims 10 to 13, said coil (4, 104, 204) being arranged around a main conductor (2, 102, 202) comprising:
- interrupting any primary current circulating in said main conductor (2, 102, 202);
- connecting a test device (20) as in any of claims 1 to 9 to said conductors (13);
- injecting in said conductors (13) one or more test signal(s) generated by said test device (20);
- processing a signal from said coil to decide whether the coil and its protection system (8) is defective or not, for example by detecting whether said protection system (8) is triggered.
